# EUROPEAN PATENT APPLICATION

(11) **EP 2 500 511 A1**
(43) Date of publication of application: **19.09.2012**
(21) Application number: 11158605.3
(22) Date of filing: 17.03.2011
(51) Int. Cl.: E21B 41/00, H01L 35/00

(54) **Supplying electrical power in a hydrocarbon well installation**

(71) Applicant: Vetco Gray Controls Limited, Bristol BS48 1BS (GB)
(72) Inventor: Ellson, Nicholas, Bristol, BS3 2DJ (GB)
(74) Representative: Emerson, Peter James

(57) **Abstract**

A method of providing electrical power in an underwater hydrocarbon well installation having a pipeline (2) surrounded by water for conveying a hydrocarbon fluid comprises attaching at least one body (1) to the pipeline at its outside, the body carrying at least one thermoelectric generating device (7), so that the device is in a temperature gradient resulting from a difference in temperature between the hydrocarbon fluid and the water surrounding the pipeline. The body comprises a clamp body which is part of a clamp arrangement clamped to the outside of the pipeline.

## Description

### Field of the Invention

The present invention relates to supplying electrical power in an underwater hydrocarbon well installation.

### Background of the Invention

In offshore oil production control systems, much of the control equipment is installed on the seabed. This subsea equipment, which essentially opens and closes subsea valves that control and allow the flow of fluid from the well, has to be highly reliable and operate in the harsh environment subsurface and is required to operate satisfactory over a life of up to 25 years. Electrical power for this equipment installed on the seabed is provided by an electrical power unit installed topside, either on a rig, floating platform or onshore for example.

The electrical power is carried to the subsea equipment via an umbilical cable, which also includes a communication link (that carries control and instrumentation signals) together with hydraulic pipelines which carry the hydraulic fluid for electrically actuated hydraulic fluid control valves. The umbilical cable may be several kilometres long, is heavy and expensive. The design of an umbilical cable is therefore critical and should be as cost-effective as possible. The configuration adopted may limit the availability of additional electrical power should modifications be required to the subsea equipment at a later date.

So-called "brown-field" developments can require more electrical power and sensing and measurements than the original umbilical cable and infield infrastructure were designed for. A method of providing small amounts of additional electrical power at a later date, without the need to modify, an umbilical cable is highly desirable. Examples of this are when additional sensors are required at the subsea installation which requires electrical power or when power is needed to operate an additional acoustic communication system (for example based on hydrophones).

### Summary of the Invention

According to the present invention from one aspect, there is provided a method of providing electrical power in an underwater hydrocarbon well installation having a pipeline for conveying a hydrocarbon fluid, the method comprising attaching at least one body to the pipeline at its outside, the body carrying at least one thermoelectric generating device, so that the device is in a temperature gradient resulting from a difference in temperature between the hydrocarbon fluid and the water surrounding the pipeline, said body comprising a clamp body which is part of a clamp arrangement clamped to the outside of said pipeline.

According to the present invention from another aspect, there is provided an arrangement for providing electrical power in an underwater hydrocarbon well installation having a pipeline for conveying a hydrocarbon fluid, the apparatus comprising at least one body attached to the pipeline at its outside, the body carrying at least one thermoelectric generating device, so that in use the device is in a temperature gradient resulting from a difference in temperature between the hydrocarbon fluid and water surrounding the pipeline, wherein said body comprises a clamp body which is part of a clamp arrangement clamped to the outside of said pipeline.

Typically, said clamp body is C-shaped. In this case, the method could comprise attaching a further such C-shaped clamp body as part of the clamp arrangement to the pipeline at its outside and opposite the first body, the further body carrying at least one thermoelectric generating device. Each of such C-shaped bodies could have a flange at each end, the bodies being clamped to the pipeline by fastening each flange to a flange of the opposite body.

Preferably, the or each thermoelectric generating device is housed in the respective body.

An embodiment of the invention is the integration of thermoelectric electrical power generating devices in the form of modules into a clamp arrangement applied around a pipeline transporting hot hydrocarbon fluid emerging from an offshore oil well and which is suitable for operating in the harsh environment at the seabed. In this configuration, there is an overall temperature difference between the temperature of the hot fluid and the temperature of sea water surrounding the pipeline and this is adequate to provide a temperature gradient across the thermoelectric modules to enable sufficient power to be generated to operate small sensors for example.

The embodiment utilises the proven characteristics of solid state semiconductor based thermoelectric electrical power generating modules when subjected to a temperature gradient across them, to generate sufficient electrical power to operate small sensors and/or other small instrumentation. Although power output and generation efficiency are very low, useful power can be obtained given the temperature gradient available.

### Brief Description of the Drawings

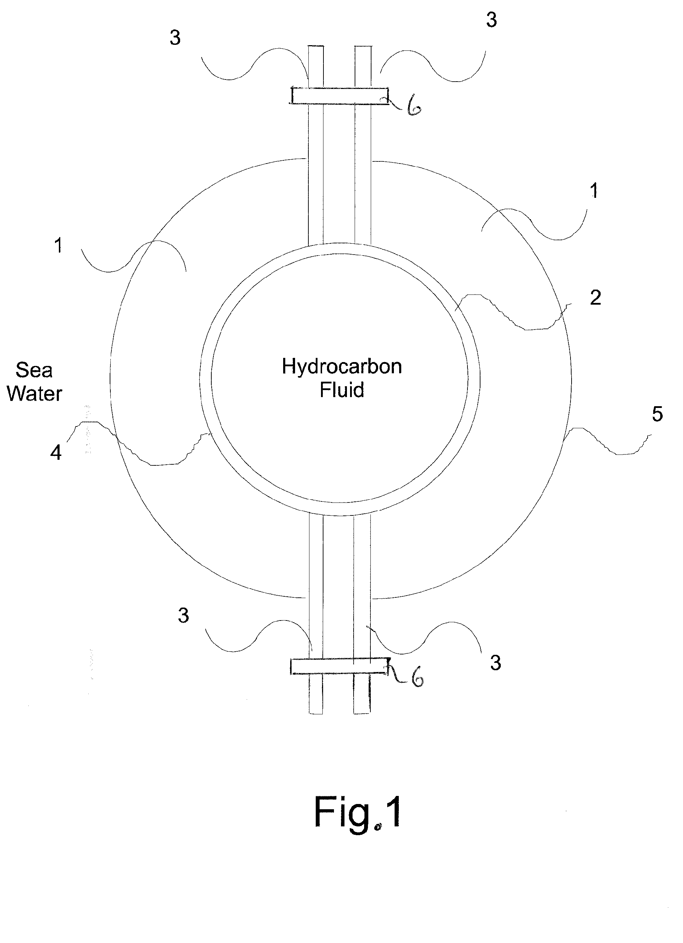

Fig. 1 is a transverse section through a pipeline having a thermoelectric power generation device attached to it according to an embodiment of the invention; and

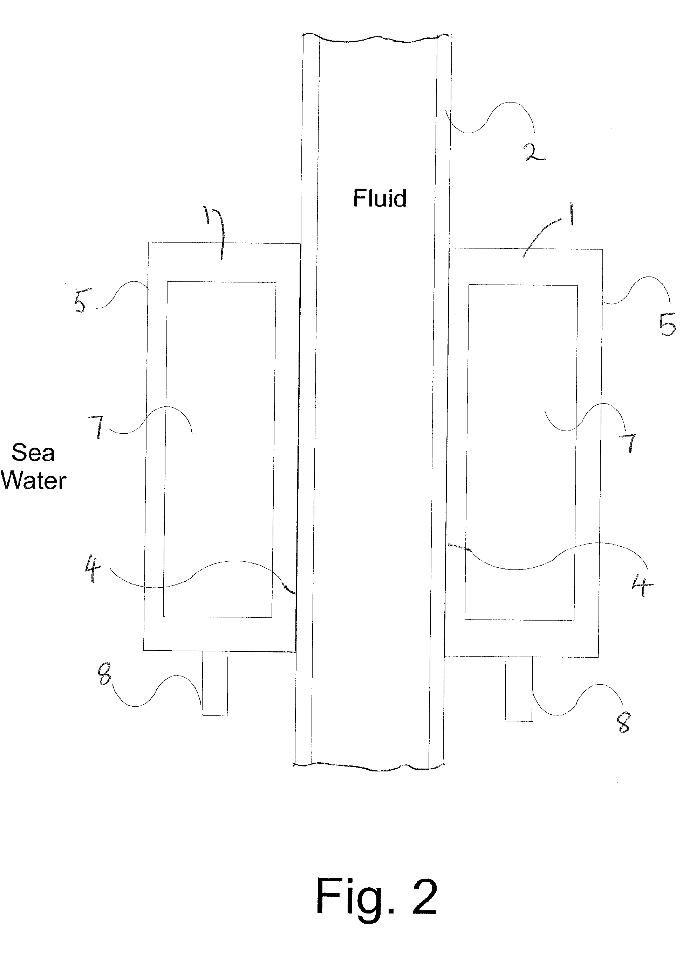

Fig. 2 is a longitudinal section through what is shown in Fig. 1.

### Description of an Embodiment of the Invention

The embodiment of the invention utilises the temperature difference between hot hydrocarbon fluid emerging up a subsea pipeline from an offshore oil well (which is typically at about 70 degrees C) and the subsea temperature outside the pipeline wall (which is typically about 5 degrees C). Calculations show that this temperature gradient can be sufficient to generate more than 3 watts of DC electrical power when utilising currently available thermoelectric modules mounted in a clamp arrangement surrounding the pipeline.

Referring to the figures, thermoelectric generation is provided by integrating sufficient solid state semiconductor based thermoelectric modules in a clamp arrangement which comprises two substantially semi-circular, C-shaped bodies 1 each forming a clamp half, which are assembled and clamped around a fluid flow pipeline 2 carrying hot hydrocarbon fluid. Each C-shaped body 1 carries a flange 3 at each end, each of which is fastened to an opposite flange 3 of the other body 1 by suitable fastening means 6. The inner surfaces 4 of the casings of the bodies 1, when installed, are in contact with the external surface of the hot hydrocarbon fluid carrying pipeline 2, while the outer surfaces 5 of the casings of the bodies 1 are in contact with the relatively cold sea water. The thermoelectric modules 7 are housed within the bodies 1, there being a temperature gradient across the thermoelectric modules.

It will be seen that the clamp is positioned around the pipeline 2 with the inner surfaces 4 of the casings of the bodies 1 arrangement in contact with the fluid pipeline while their external surfaces 5 are in contact with the sea water, the semiconductor based thermoelectric power generation modules 7 being housed inside the casings of the bodies 1. Electrical connections 8 are brought out to a subsea connector at the base of the arrangement (which may be permanently or temporarily connected to the load(s) using dry or wet male connectors). The length of the surfaces 4 in contact with the fluid pipeline 2 will depend on the output power required by the load(s), such as sensor(s) and/or other instrumentation.

Typically, the clamp arrangement is deployable or retrievable subsea by a remotely operated vehicle (ROV).

Suitable thermoelectric modules are available on the market in several physical sizes (such as 0.5 inch x 0.5 inch, 1 inch x 1 inch) which are suitable for packaging in a corrosion proof clamp arrangement. Use can be made of the relatively high mechanical strength in a compression mode (shear strength is comparatively low). When modules are installed using the above clamping method, sufficient pressure will have to be maintained on them so that a module is not "loose" so that it may easily be moved by applying a small lateral force.

Thermoelectric modules are highly reliable components due to their solid state construction and provide long, trouble-free service.

### Advantages of Using the Invention

Solid state power generation with no moving parts.

DC power generation, no need for conversion.

Uses low power, low cost thermoelectric modules used in a variety of applications. Clamp-on installation simplifies retrofitting.

Enables more sensors and measurements to be a added to brown-field facility. Reduced infrastructure required on a green-field installation.

## Claims

1. A method of providing electrical power in an underwater hydrocarbon well installation having a pipeline for conveying a hydrocarbon fluid, the method comprising attaching at least one body to the pipeline at its outside, the body carrying at least one thermoelectric generating device so that the device is in a temperature gradient resulting from a difference in temperature between the hydrocarbon fluid and the water surrounding the pipeline, said body comprising a clamp body which is part of a clamp arrangement clamped to the outside of said pipeline.

2. A method according to claim 1, wherein said clamp body is C-shaped.

3. A method according to claim 2, comprising attaching a further such C-shaped clamp body as part of the clamp arrangement to the pipeline at its outside and opposite the first body, the further body carrying at least one thermoelectric generating device.

4. A method according to claim 3, wherein each of the C-shaped bodies has a flange at each end, the bodies being clamped to the pipeline by fastening each flange to a flange of the opposite body.

5. A method according to any preceding claim, wherein the or each thermoelectric generating device is housed in the respective body.

6. A method according to any preceding claim, comprising clamping said clamp arrangement to said pipeline using an ROV.

7. An arrangement for providing electrical power in an underwater hydrocarbon well installation having a pipeline for conveying a hydrocarbon fluid, the apparatus comprising at least one body attached to the pipeline at its outside, the body carrying at least one thermoelectric generating device, so that in use the device is in a temperature gradient resulting from a difference in temperature between the hydrocarbon fluid and water surrounding the pipeline, wherein said body comprises a clamp body which is part of a clamp arrangement clamped to the outside of said pipeline.

8. An arrangement according to claim 7, wherein said body is C-shaped.

9. An arrangement according to claim 8, comprising a further such C-shaped clamp body attached to the pipeline at its outside and opposite the first body as part of the clamp arrangement, the further body carrying at least one thermoelectric generating device.

10. An arrangement according to claim 9, wherein each of the C-shaped members has a flange at each end, the bodies being clamped to the pipeline by fastening means which fasten each flange to a flange of the opposite body.

11. An arrangement according to any of claims 7 to 10, wherein the or each thermoelectric generating device is housed in the respective body.
